# EUROPEAN PATENT SPECIFICATION

(11) **EP 3 961 695 B1**
(45) Date of publication and mention of the grant of the patent: **02.08.2023**
(21) Application number: 20794822.5
(22) Date of filing: 17.04.2020
(51) Int. Cl.: H01L 23/373, H01L 23/498, H05K 1/02, H01L 23/15, H01L 23/36

(54) **CERAMIC CIRCUIT SUBSTRATE AND ELECTRONIC COMPONENT MODULE**
KERAMIKSCHALTSUBSTRAT UND ELEKTRONISCHES KOMPONENTENMODUL
SUBSTRAT DE CIRCUIT CÉRAMIQUE ET MODULE DE COMPOSANT ÉLECTRONIQUE

(30) Priority: 26.04.2019 JP 2019086124
(43) Date of publication of application: 02.03.2022
(73) Proprietor: Denka Company Limited, Tokyo 103-8338 (JP)
(72) Inventor: NAKAHARA, Fumihiro, Tokyo 103-8338 (JP); AONO, Ryohta, Tokyo 103-8338 (JP); YANO, Seiji, Tokyo 103-8338 (JP)
(74) Representative: Gulde & Partner
(86) International application number: PCT/JP2020/016884
(87) International publication number: WO 2020/218193

(56) References cited:
- WO-A1-2015/114987
- WO-A1-2018/225809
- WO-A1-2018/225809
- JP-A- 2005 072 456
- JP-A- 2005 072 456
- JP-A- 2005 101 353
- JP-A- 2007 258 416
- JP-A- 2019 041 108
- US-A1- 2019 084 893

## Description

### TECHNICAL FIELD

The present invention relates to a ceramic circuit board and an electronic component module.

### BACKGROUND ART

Various developments have been made on a ceramic circuit board. As such a technique, for example, a technique disclosed in Patent Document 1 has been known. Patent Document 1 discloses a ceramic circuit board in which a circuit layer is constituted of a first circuit layer made of a brazing material and a second circuit layer made of a metal circuit board bonded to a surface of a ceramic board with the brazing material interposed therebetween (Claim 1 in Patent Document 1) . Claim 6 in Patent Document 1 discloses that a plating layer is formed on a surface of the second circuit layer made of the metal circuit board. Patent Document 2 relates to a ceramic circuit substrate having a copper plate bonded, by a braze material, to both main surfaces of a ceramic substrate comprising aluminum nitride or silicon nitride, the copper plate of at least one of the main surfaces being subjected to silver plating. Patent Document 3 discloses a ceramic circuit board composed of a ceramic substrate and a metal circuit board, the metal circuit board is formed on at least one principal surface of the ceramic substrate, and a recess wherein an electric element is packaged and which is formed on the principal surface of the metal circuit board opposed to a side that is abutted with the ceramic substrate. Patent Document 3 relates to a substrate for a power module comprising: a ceramic substrate; a metal plate that is joined to a surface of the ceramic substrate; and a metallic film that is partially provided on the metal plate, where the metal plate has concave parts, and the metallic film is provided on a bottom surface of the concave parts.

### RELATED DOCUMENT

### PATENT DOCUMENT

[Patent Document 1] JP 2005-101415 A
[Patent Document 2] WO 2018/225809 A1
[Patent Document 3] JP 2005 072456 A
[Patent Document 4] JP 2019 041108 A

### SUMMARY OF THE INVENTION

However, as a result of examination by the present inventor, it has been found that the ceramic circuit board disclosed in Patent Document 1 has room for improvement in connection reliability when used in an electronic component module.

The plating layer formed on the surface of the metal circuit board improves the wettability of solder. Therefore, it is considered that the adhesion between the metal circuit board and the electronic component can be improved by solder bonding.

However, as a result of examination of a contact surface of the plating layer in contact with the surface of the metal circuit board, it has been found that when stress concentration occurs in a tip portion of the plating layer and stress is applied in an in-plane direction, peeling of the plating layer occurs. When the electronic component module is exposed to a high-temperature environment such as solder bonding with the higher output and higher integration of the electronic component module, the occurrence frequency of such peeling becomes even higher.

Therefore, as a result of further examination by the present inventor based on such circumstances, it has been found that by forming a recess on the surface of the metal circuit board and forming the plating layer in the recess, the stress concentration described above is eliminated on the contact surface of the plating layer in contact with the surface of the metal circuit board, and the peeling of the plating layer can be suppressed.

It has been found that an electronic component module having excellent connection reliability can be realized by using a ceramic circuit board having a plating layer in such a recess, whereby the present invention has been completed.

According to the present invention, there is provided a ceramic circuit board including a silicon nitride substrate, a copper heat radiating plate provided on one surface of the silicon nitride substrate, a copper circuit board provided on the other surface of the silicon nitride substrate, and a silver-plated layer provided on at least a part of the other surface of the copper circuit board, which is located on a side opposite to a main surface of the copper circuit board facing the other surface of the silicon nitride substrate, in which the silver-plated layer is formed in a recess provided on the other surface of the copper circuit board and a part of the lower surface of the silver-plated layer is formed in a region outside the recess.

Further, according to the present invention, there is provided an electronic component module including the ceramic circuit board, an electronic component provided on the copper circuit board of the ceramic circuit board, and a heat sink provided on the copper heat radiating plate of the ceramic circuit board.

According to the present invention, there are provided a ceramic circuit board having excellent connection reliability when used in an electronic component module, and an electronic component module using the ceramic circuit board.

### BRIEF DESCRIPTION OF THE DRAWINGS

Figs. 1A and 1B are diagrams schematically showing an example of a configuration of a ceramic circuit board of the present embodiment, in which Fig. 1A is a side view and Fig. 1B is a top view.
Figs. 2A 2B and 2C are cross-sectional views of steps for schematically showing an example of a process of forming a silver-plated layer.
Fig. 3 is a cross-sectional view schematically showing an example of an electronic component module of the present embodiment.
Figs. 4A and 4B show SEM images of a cross section of a ceramic circuit board of Example 1 in a thickness direction.
Figs. 5A and 5B show SEM images of a cross section of a ceramic circuit board of Comparative Example 1 in a thickness direction.

### DESCRIPTION OF EMBODIMENTS

Hereinafter, embodiments of the present invention will be described with reference to the drawings. In all drawings, the same components are denoted by the same reference numerals, and description thereof will not be repeated. In addition, the figure is a schematic diagram and does not correspond to the actual dimensional ratio.

In the present embodiment, the front-back, left-right, and up-down directions are defined as shown in the figure. However, the definition is merely provided for convenience in order to briefly describe relative relationships among the components. Accordingly, it is not intended to limit the direction in which the product according to the present invention is manufactured or used.

An outline of a ceramic circuit board of the present embodiment is as follows.

The ceramic circuit board of the present embodiment includes a silicon nitride substrate, a copper heat radiating plate provided on one surface of the silicon nitride substrate, a copper circuit board provided on the other surface of the silicon nitride substrate, and a silver-plated layer provided on at least a part of the other surface of the copper circuit board, which is located on a side opposite to a main surface of the copper circuit board facing the other surface of the silicon nitride substrate. In the ceramic circuit board, the silver-plated layer is formed in a recess provided on the other surface of the copper circuit board.

According to the findings of the present inventor, peeling of the silver-plated layer can be suppressed by forming the silver-plated layer in the recess on the surface of the metal circuit board.

The detailed mechanism is not clear, but the following can be considered.

A plating layer provided on a flat surface has a stress concentration point α at a tip portion in contact with the flat surface. Since the stress is applied in an in-plane direction from the stress concentration point α as a base point, there is a concern that interfacial peeling occurs in the plating layer.

On the other hand, since a plating layer provided on a recessed surface has no stress concentration point α from which the stress is applied in the in-plane direction, it is considered that peeling of the plating layer can be suppressed.

An electronic component module of the present embodiment includes the ceramic circuit board, an electronic component provided on the copper circuit board of the ceramic circuit board, and a heat sink provided on the copper heat radiating plate of the ceramic circuit board.

By using the ceramic circuit board described above, it is possible to improve the connection reliability of the electronic component module.

Hereinafter, each configuration of the ceramic circuit board of the present embodiment will be described in detail.

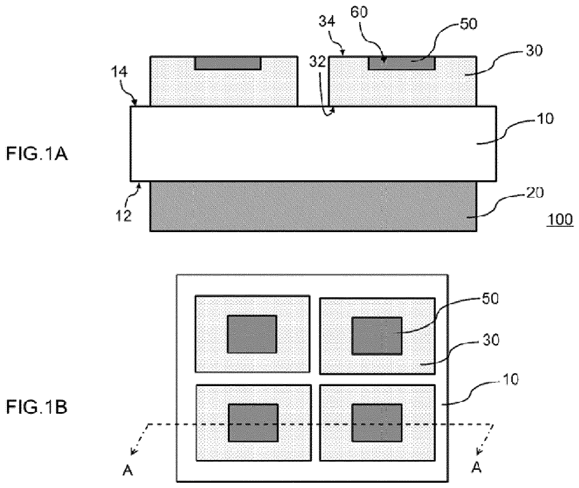

Figs. 1A and 1B are diagrams schematically showing an example of a configuration of a ceramic circuit board 100, in which Fig. 1A is a side view and Fig. 1B is a top view. Note that Fig. 1A is a cross-sectional view taken along the line A-A of Fig. 1B.

The ceramic circuit board 100 includes a silicon nitride substrate 10, a copper heat radiating plate 20 provided on one surface 12 of the silicon nitride substrate 10, and a copper circuit board 30 provided on the other surface 14 of the silicon nitride substrate 10.

The silicon nitride substrate 10 is a white ceramic board containing Si₃N₄ as a main component. The silicon nitride substrate 10 has excellent mechanical strength, insulation, and thermal conductivity.

A cross-sectional shape of the silicon nitride substrate 10 in the cross-sectional view in the thickness direction may be substantially rectangular.

In addition, a planar shape of the silicon nitride substrate 10 when viewed from the perpendicular direction of one surface 12 is not limited as long as it is a practical shape, but may be, for example, substantially rectangular.

A thickness of the silicon nitride substrate 10 is not limited as long as it is within a practical range, but is, for example, 0.2 mm to 1.5 mm, preferably 0.2 mm to 1.0 mm, and more preferably 0.2 mm to 0.7 mm.

In the present specification, the term "to" means to include an upper limit value and a lower limit value unless otherwise specified.

The term "substantially" means to include a range in consideration of manufacturing tolerances, variations, and the like, unless otherwise specified.

The copper heat radiating plate 20 is a copper plate containing Cu as a main component. As the copper heat radiating plate 20, a Cu plate may be used, but a Cu alloy plate made of a Cu-Mo alloy or a multilayer Cu plate made of Cu/Mo/Cu may be used.

The copper heat radiating plate 20 is used as a copper plate for bonding a heat sink.

A cross-sectional shape of the copper heat radiating plate 20 in the cross-sectional view in the thickness direction may be substantially rectangular.

In addition, a planar shape of the copper heat radiating plate 20 when viewed from the perpendicular direction of one surface 12 is not limited as long as it is a practical shape, but may be, for example, substantially rectangular.

A thickness of the copper heat radiating plate 20 is not limited as long as it is within a practical range, but is, for example, 0.15 mm to 4.0 mm, preferably 0.15 mm to 1.0 mm, and more preferably 0.30 mm to 1.0 mm.

A size of copper particles (average crystal grain size of the copper crystal) of the copper heat radiating plate 20 is, for example, equal to or more than 30 um and equal to or less than 600 µm, preferably equal to or more than 50 um and equal to or less than 500 µm, and more preferably equal to or more than 100 um and equal to or less than 300 um. By setting the average crystal grain size of the copper crystal in the copper heat radiating plate 20 within the above numerical range, poor bonding strength or poor thermal resistance can be further reduced.

The copper circuit board 30 is a copper plate which is composed of a copper layer containing Cu as a main component and has a circuit pattern. As the copper circuit board 30, a Cu plate may be used, but a Cu alloy plate made of a Cu-Mo alloy or a multilayer Cu plate made of Cu/Mo/Cu may be used. The copper circuit board 30 is electrically connected to an electronic component, an external connection terminal, or the like.

A cross-sectional shape of the copper circuit board 30 in the cross-sectional view in the thickness direction may be substantially rectangular.

In addition, a planar shape of the copper circuit board 30 when viewed from the perpendicular direction of the other surface 14 of the silicon nitride substrate 10 is not limited as long as it is a practical shape as a circuit pattern, but may be, for example, substantially rectangular or substantially polygonal.

A thickness of the copper circuit board 30 is not limited as long as it is within a practical range, but is, for example, 0.15 mm to 4.0 mm, preferably 0.15 mm to 1.0 mm, and more preferably 0.30 mm to 1.0 mm.

A size of copper particles (average crystal grain size of the copper crystal) of the copper circuit board 30 is, for example, equal to or more than 30 um and equal to or less than 600 µm, preferably equal to or more than 50 um and equal to or less than 500 µm, and more preferably equal to or more than 100 um and equal to or less than 300 um. By setting the average crystal grain size of the copper crystal in the copper circuit board 30 within the above numerical range, poor bonding strength or poor thermal resistance can be further reduced. Although the mechanism is not clear, it is presumed that the stress is moderately relaxed in the copper circuit board 30 due to, for example, the copper crystal causing the grain boundary sliding moderately.

The silicon nitride substrate 10 and the copper heat radiating plate 20 may be directly bonded to each other, or may be bonded with a bonding material layer interposed therebetween. Similarly, the silicon nitride substrate 10 and the copper circuit board 30 may be directly bonded to each other, or may be bonded with a bonding material layer interposed therebetween. The bonding materials may be the same or different from each other.

A brazing material can be used as the bonding material.

As the brazing material, a silver-copper brazing material containing at least one active metal selected from titanium (Ti), indium (In), zirconium (Zr), hafnium (Hf), niobium (Nb), tantalum (Ta), vanadium (V), aluminum (Al), and tin (Sn) can be used. Specifically, an Ag-Cu-Ti brazing material, an Ag-Cu-In-Ti brazing material, and an Ag-Cu-Sn-Ti brazing material can be used. These materials may be used alone or in combination of two or more.

A compounding ratio of Ag, Cu, and Sn or In may be, for example, Ag: equal to or more than 85.0 parts by mass and equal to or less than 95.0 parts by mass, Cu: equal to or more than 5.0 parts by mass and equal to or less than 13.0 parts by mass, and Sn or In: equal to or more than 0.4 parts by mass and equal to or less than 3.5 parts by mass. By setting the value within the above numerical range, it is possible to prevent a melting temperature of the brazing material from being excessively increased and to enable bonding at an appropriate temperature, and thus it is possible to reduce thermal stress caused by a difference in thermal expansion coefficient at the time of bonding and to improve a heat resistance cycle property.

The amount of the active metal such as titanium added may be, for example, equal to or more than 1.5 parts by mass and equal to or less than 5.0 parts by mass with respect to 100 parts by mass in total of Ag, Cu, and Sn or In. By appropriately adjusting the amount of the active metal added, it is possible to further enhance the wettability to the ceramic plate, and to further suppress the occurrence of defective bonding.

A silver-copper brazing material layer may be provided in at least one of a space between the copper heat radiating plate 20 and the silicon nitride substrate 10 and a space between the copper circuit board 30 and the silicon nitride substrate 10 and the silver-copper brazing material of the silver-copper brazing material layer is selected from an Ag-Cu-Ti brazing material, an Ag-Cu-In-Ti brazing material, and an Ag-Cu-Sn-Ti brazing material or a combination thereof, wherein the compounding ratio of Ag, Cu, and Sn or In is Ag: equal to or more than 85.0 parts by mass and equal to or less than 95.0 parts by mass, Cu: equal to or more than 5.0 parts by mass and equal to or less than 13.0 parts by mass, and Sn or In: equal to or more than 0.4 parts by mass and equal to or less than 3.5 parts by mass.

A thickness of the silver-copper brazing material layer is not limited as long as it is within a practical range, but is, for example, equal to or more than 3 um and equal to or less than 40 µm, and preferably equal to or more than 4 um and equal to or less than 25 µm.

In the ceramic circuit board 100 in Fig. 1A, a thickness of the silicon nitride substrate 10 is T1, a thickness of the copper heat radiating plate 20 is T2, and a thickness of the copper circuit board 30 is T3.

In this case, T1, T2, and T3 may be configured to satisfy, for example, 1 ≤ (T2 + T3)/T1 ≤ 15. The upper limit of (T2 + T3)/T1 may be equal to or less than 15, or may be equal to or less than 10. As a result, the resistance of the ceramic circuit board 100 to a thermal cycle can be improved. On the other hand, the lower limit of (T2 + T3)/T1 is not particularly limited, but may be equal to or more than 1, or may be equal to or more than 2.

In the ceramic circuit board 100 in Fig. 1B, one or more copper circuit boards 30 may be formed in a plane of the other surface 14 of the silicon nitride substrate 10. One copper heat radiating plate 20 need only be formed on one surface 12 of the silicon nitride substrate 10, and a plurality of the copper heat radiating plates 20 may be formed in a plane of one surface 12.

The ceramic circuit board 100 includes a silver-plated layer 50 provided on at least a part of the other surface 34 of the copper circuit board 30. The solder wettability is enhanced by the silver-plated layer 50. Therefore, it is possible to improve the adhesion between the copper circuit board 30 and the electronic component. A plating layer such as a silver-plated layer may also be formed on the surface side of the copper heat radiating plate 20 bonded to a heat sink.

The silver-plated layer 50 can be made of a material of practical use, but contains Ag as a main component. In addition to Ag, the silver-plated layer 50 may contain other elements, such as Ni and P.

In the ceramic circuit board 100 in Fig. 1A, the silver-plated layer 50 is formed in a recess 60 provided on the other surface 34 of the copper circuit board 30.

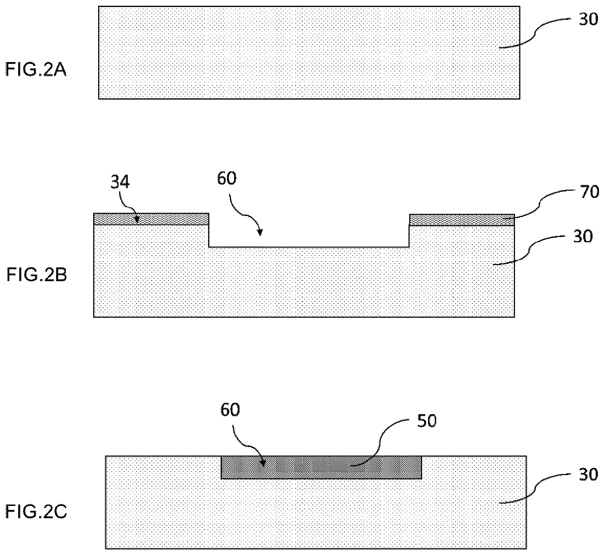

Figs. 2A to 2C are cross-sectional views of steps for schematically showing an example of a process of forming the silver-plated layer 50.

As shown in Fig. 2A, the copper circuit board 30 having a circuit pattern is formed on the silicon nitride substrate 10.

As one specific method, for example, a copper plate is bonded to the silicon nitride substrate 10. Then, the copper plate is subjected to an etching treatment to form the copper circuit board 30 having a circuit pattern. The other surface 34 of the copper circuit board 30 may be subjected to a chemical polishing treatment.

Subsequently, as shown in Figs. 2B and 2C, the recess 60 is formed on the other surface 34 of the copper circuit board 30. The silver-plated layer 50 is formed inside the recess 60.

One specific method will be described.

First, on the other surface 34 of the copper circuit board 30, a resist 70 having an opening pattern is formed in a mounting region in which an electronic component such as a semiconductor element is mounted. For example, a pattern is formed on the resist 70 by screen printing or an exposure method. The region of the other surface 34 covered with the resist 70 corresponds to a non-mounting region.

Subsequently, the other surface 34 of the copper circuit board 30 in the resist 70 is subjected to a plating pretreatment. As the plating pretreatment, degreasing may be performed using a degreasing solution for copper. Further, the surface of the other surface 34 is cleaned. After that, the recess 60 recessed from the other surface 34 in the direction of one surface 32 is formed on the surface of the other surface 34 by using a copper etching solution such as a sulfuric acid-hydrogen peroxide mixture containing sulfuric acid and hydrogen peroxide. In the formation of the recess 60, for example, a long-time treatment is performed in order to form a recess deeper than usual in the present invention. In this case, a copper oxide film formed on the surface of the other surface 34 can be removed. Therefore, the adhesion between the surface inside the recess 60 and the silver-plated layer 50 can be improved. Subsequently, as necessary, cleaning or drying may be performed.

Subsequently, the silver-plated layer 50 is formed inside the recess 60 by an electroless plating method or the like.

After that, the resist 70 is removed using a peeling liquid. As the resist peeling liquid, a known chemical liquid may be used, but it is preferable to use a peeling liquid having low corrosiveness to copper. For example, as a peeling liquid having low corrosiveness to copper, caustic soda (sodium hydroxide aqueous solution) is used. In addition, when caustic soda or the like is used, side etching is less likely to occur.

According to the findings of the present inventor, it has been found that when a potassium hydroxide aqueous solution is used as the resist peeling liquid, an undercut occurs below the silver-plated layer 50. It is considered that the potassium hydroxide aqueous solution flowed under a peripheral edge of the silver-plated layer 50 and corroded a part of the surface of the copper circuit board 30. Contamination or oxidation occurs in the undercut under the silver-plated layer 50, which may lead to deterioration of adhesion and connection reliability.

On the other hand, it has been found that the occurrence of the above-described undercut can be suppressed by using a peeling liquid having low corrosiveness to copper such as a sodium hydroxide aqueous solution as the resist peeling liquid. As a result, it possible to improve the adhesion between the copper circuit board 30 and the silver-plated layer 50 and to improve the connection reliability.

After removing the resist 70, the surface of the copper circuit board 30, the silver-plated layer 50, or the copper heat radiating plate 20 may be subjected to alkaline cleaning. In the alkaline cleaning, the concentration of the chemical liquid and the number of times of repetition are appropriately selected.

The surface of the copper heat radiating plate 20 and the copper circuit board 30 after the alkaline cleaning may not be treated with a rust preventive agent generally used for a copper plate such as benzotriazole. The generation of impurities at the bonding interface can be suppressed.

As a result, as shown in Fig. 2C, the silver-plated layer 50 can be formed in the recess 60 of the copper circuit board 30.

In one of cross-sectional views of the copper circuit board 30 when viewed in the thickness direction, the copper circuit board 30 may be configured not to include a side etching portion below a region where the silver-plated layer 50 is formed.

The lower surface of the silver-plated layer 50 is configured such that at least a part or the whole of the lower surface is in contact with the other surface 34 of the copper circuit board 30. In the copper circuit board 30 that does not include the side etching portion, the whole lower surface of the silver-plated layer 50 is in contact with the other surface 34. A part of the lower surface of the silver-plated layer 50 is formed in a region outside the recess 60.

The silver-plated layer 50 is configured to fill at least part or the whole of the recess 60. The silver-plated layer 50 that fills a part of the recess 60 can be formed along the surface of the other surface 34 in the recess 60.

In one of cross-sectional views of the copper circuit board 30 when viewed in the thickness direction, the silver-plated layer 50 may have a substantially U shape that is open in a direction from one surface 32 side to the other surface 34 side of the copper circuit board 30. As a result, compared with the case where the surface of the silver-plated layer 50 is made of a flat surface, the adhesion between the silver-plated layer 50 and solder can be improved by increasing of the contact area with solder and the under-effect of solder.

The upper limit of a depth of the recess 60 measured by two-dimensional contour shape measurement is, for example, equal to or less than 50 µm, preferably equal to or less than 35 µm, and more preferably equal to or less than 25 um. As a result, the connection stability at the time of solder connection can be improved. The lower limit of the depth of the recess 60 is, for example, equal to or more than 1 um, preferably equal to or more than 2 µm, and more preferably equal to or more than 3 um. As a result, the adhesion between the silver-plated layer 50 and the copper circuit board 30 can be improved.

When the other surface 34 of the copper circuit board 30 is viewed from the perpendicular direction, the lower limit of a coating area of the silver-plated layer 50 with respect to the entire surface in the recess 60 is, for example, equal to or more than 80%, preferably equal to or more than 85%, and more preferably equal to or more than 90%. As a result, the bondability of the semiconductor element by silver sintering bonding can be improved. The upper limit of the coating area of the silver-plated layer 50 with respect to the surface in the recess 60 is not particularly limited, but may be equal to or less than 100%, or may be equal to or less than 99%.

When the other surface 34 of the copper circuit board 30 is viewed from the perpendicular direction, the lower limit of a coating area of the silver-plated layer 50 with respect to the entire surface on the other surface 34 side of the copper circuit board 30 is, for example, equal to or more than 10%, preferably equal to or more than 30%, and more preferably equal to or more than 45%. As a result, the solder bondability can be improved. The upper limit of the coating area of the silver-plated layer 50 with respect to the other surface 34 is not particularly limited, but may be equal to or less than 90%, or may be equal to or less than 80%. As a result, the mechanical strength of the other surface 34 of the copper circuit board 30 located outside the recess 60 in the in-plane direction is increased.

In addition, the side surface of the copper circuit board 30 need not have the silver-plated layer 50 formed thereon. Thus, the stress applied to the silver-plated layer 50 can be suppressed due to the difference in coefficient of linear expansion or the difference in degree of deformation that occurs between the other surface 34 side and the side surface side of the copper circuit board 30. As a result, the peeling between the copper circuit board 30 and the silver-plated layer 50 can be suppressed.

A thickness of the silver-plated layer 50 is, for example, equal to or more than 0.1 um and equal to or less than 3.0 um or less, preferably equal to or more than 0.2 um and equal to or less than 2.0 um, and more preferably equal to or more than 0.3 um and equal to or less than 1.0 um.

The depth of the recess 60 is preferably larger than the thickness of the silver-plated layer 50, and more preferably, the depth of the recess 60 is equal to or more than 2 times the thickness of the silver-plated layer 50.

A surface roughness Ra of the silver-plated layer 50 measured in accordance with JIS B 0601-1994 is, for example, equal to or more than 0.01 um and equal to or less than 0.9 µm, and preferably equal to or more than 0.1 um and equal to or less than 0.6 um. By setting the surface roughness of the silver-plated layer 50 within the above range, it is possible to improve the adhesion between the silver-plated layer 50 and the solder.

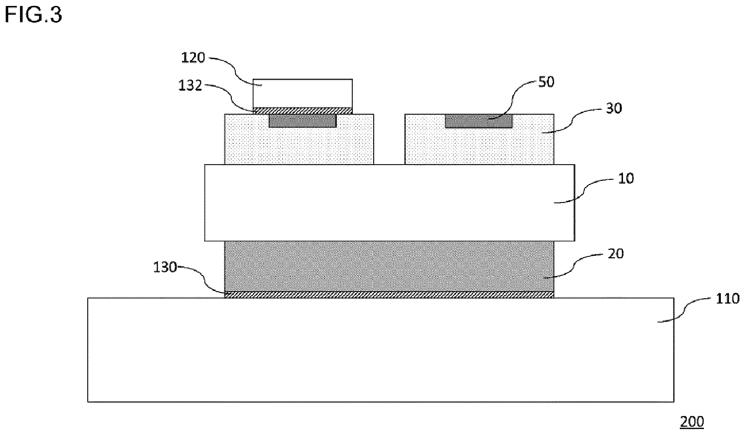

Fig. 3 is a cross-sectional view schematically showing an example of an electronic component module 200 of the present embodiment.

The electronic component module 200 includes an electronic component 120 such as a semiconductor element mounted on the ceramic circuit board 100. The electronic component 120 may be electrically connected to the copper circuit board 30, a lead frame for external connection, or the like by wire bonding.

For the electronic component 120, various semiconductor elements such as an insulated gate bipolar transistor (IGBT), a metal oxide semiconductor field effect transistor (MOSFET), and a free wheeling diode (FWD) can be selected according to a desired function.

The electronic component module 200 includes a heat sink 110 provided on the copper heat radiating plate 20. As a result, heat conduction from the ceramic circuit board 100 to the heat sink 110 can be improved.

The heat sink 110 is formed of, for example, a material having high thermal conductivity such as aluminum, copper, or an alloy thereof, and may be formed of aluminum or an aluminum alloy.

The electronic component 120 may be solder-bonded to the copper circuit board 30 with a solder layer 132 interposed therebetween. In addition, the heat sink 110 may be solder-bonded to the copper heat radiating plate 20 with a solder layer 130 interposed therebetween.

As a solder material used for the solder layer 130 and the solder layer 132, a known solder material may be used, and for example, Sn-Sb, Sn-Ag, Sn-Cu, Sn-In, or Sn-Ag-Cu solder material (so-called lead-free solder material) may be used.

The electronic component module 200 may include a sealing resin layer (not shown) that seals the electronic component 120. The sealing resin layer may seal a part or the whole of the ceramic circuit board 100.

The sealing resin portion can be formed by curing a resin composition for forming the sealing resin portion.

The type of the resin composition for forming the sealing resin portion is not particularly limited, and a resin composition usually used in the art, such as a resin composition for transfer molding, a resin composition for compression molding, and a liquid sealing material, can be used.

The resin composition for forming the sealing resin portion preferably contains a thermosetting resin, preferably one or more selected from an epoxy resin, a phenol resin, a cyanate resin, a bismaleimide triazine resin, an acrylic resin, and a silicone resin, and more preferably contains at least an epoxy resin.

The resin composition for forming the sealing resin portion may further contain a curing agent, a filler, and the like.

Examples of the filler include powders of fused silica (spherical silica), crystalline silica, alumina, silicon carbide, silicon nitride, aluminum nitride, boron nitride, beryllia, zirconia, and the like or sphericalized beads thereof, glass fibers, aramid fibers, and carbon fibers. One kind of the filler may be used alone or two or more kinds of the filler may be used in combination.

### Examples

Hereinafter, the present invention will be described in detail with reference to Examples, but the present invention is not limited to the description of these Examples.

### <Manufacturing of Ceramic Circuit Board>

To 91.4 parts by mass of silicon nitride raw material having an average particle size of 0.7 um, 6.0 parts by mass of Y₂O₃ and 1.5 parts by mass of MgO were added as a sintering additive, and an organic solvent, an organic binder, a plasticizer, and the like were mixed thereinto and uniformly mixed by a ball mill to obtain a raw material slurry. The raw material slurry was defoamed and thickened, and then sheet molded by a doctor blade method to obtain a molded body. The obtained sheet molded body was cut, degreased at 500°C, and fired in a firing furnace at 1850°C for 5 hours in a nitrogen atmosphere to prepare a silicon nitride substrate.

As a brazing material (containing active metal), a brazing material containing 3.5 parts by mass of titanium hydride powder (TCH-100 manufactured by Toho Technical Service Co., Ltd.) was prepared with respect to 100 parts by mass in total of 89. 5 parts by mass of Ag powder (Ag-HWQ 2.5 um manufactured by Fukuda Metal Foil & Powder Co., Ltd.), 9.5 parts by mass of Cu powder (Cu-HWQ 3 um manufactured by Fukuda Metal Foil & Powder Co., Ltd.), and 1.0 part by mass of Sn powder (Sn-HPN 3 um manufactured by Fukuda Metal Foil & Powder Co., Ltd.).

The brazing material described above, a binder resin, and a solvent were mixed to obtain a brazing material paste. This brazing material paste was applied to both surfaces of the silicon nitride substrate by a screen printing method so that the dry thickness on each surface was about 10 um.

After that, a copper plate was stacked on both surfaces of the silicon nitride substrate, heated in a vacuum of equal to or less than 1.0 × 10⁻³ Pa at 780°C for 30 minutes, and the silicon nitride substrate and the copper plate were bonded to each other with a brazing material. As a result, a silicon nitride-copper composite in which the silicon nitride substrate and the copper plate were bonded to each other with the brazing material was obtained.

An etching resist was printed on the obtained silicon nitride-copper composite copper layer and etched with a ferric chloride solution to form a circuit pattern.

### (Example 1)

A resist having an opening pattern was screen-printed on the surface of a copper plate (copper circuit board) on which a circuit pattern was formed.

The surface of the copper circuit board in the resist opening was subjected to a degreasing treatment and cleaned with water.

The surface inside the resist opening was etched using a sulfuric acid-hydrogen peroxide mixture containing sulfuric acid and hydrogen peroxide to form a recess.

After etching, a silver-plated layer was formed in the recess by electroless plating. The etching treatment conditions and electroless plating conditions described above were adjusted so that the depth of the recess was equal to or more than 2.5 times the thickness of the silver-plated layer.

After that, the resist was removed using a sodium hydroxide aqueous solution to manufacture a ceramic circuit board (silicon nitride circuit board).

### (Comparative Example 1)

A ceramic circuit board was manufactured in the same manner as in Example 1 except that a sulfuric acid aqueous solution of about 10% was used instead of the sulfuric acid-hydrogen peroxide mixture and a potassium hydroxide aqueous solution was used instead of the sodium hydroxide aqueous solution.

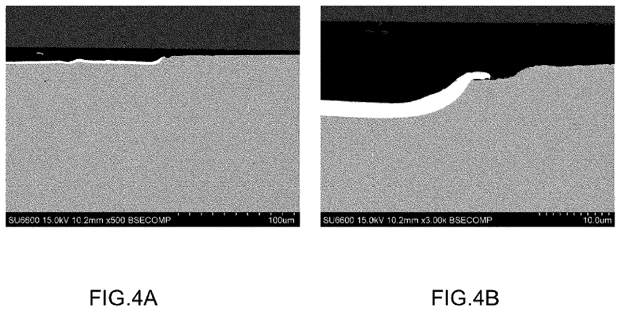

Figs. 4A and 4B show SEM images of a cross section of the ceramic circuit board of Example 1 in the thickness direction. Fig. 4B is an enlarged view of Fig. 4A.

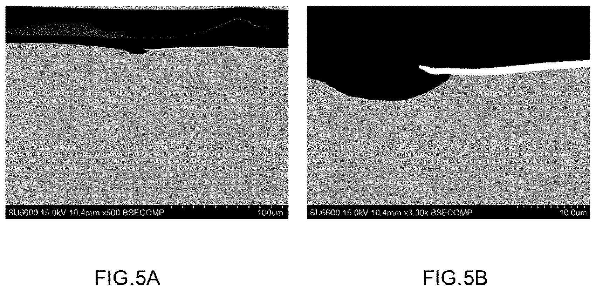

In addition, Figs. 5A and 5B show SEM images of a cross section of the ceramic circuit board of Comparative Example 1 in the thickness direction. Fig. 5B is an enlarged view of Fig. 5A.

In Figs. 4A and 4B, a structure in which the silver-plated layer was formed in the recess was observed. On the other hand, in Figs. 5A and 5B, it was observed that the silver-plated layer was formed on the surface of the copper circuit board, and the recess in which the silver-plated layer 50 was provided was not formed. In addition, in Figs. 5A and 5B, it was observed that a side etching portion was formed below the silver-plated layer.

In the ceramic circuit board of Example 1, the peeling of the silver-plated layer tends to be more suppressed at the time of solder connection or under a repeated use environment than in the ceramic circuit board of Comparative Example 1. Therefore, when the ceramic circuit board is used in an electronic component module on which a semiconductor element is mounted, the bondability of the semiconductor element by silver sintering bonding can be improved, and the connection reliability of the semiconductor element can be improved.

### (Example 2)

In Example 2, the etching treatment conditions and electroless plating conditions were adjusted so that the depth of the recess was equal to the thickness of the silver-plated layer. The peeling tended to occur somewhat more easily than in Example 1, but the peeling was less likely to occur than in Comparative Example 1.

### REFERENCE SIGNS LIST

- 10:: silicon nitride substrate
- 12:: one surface
- 14:: the other surface
- 20:: copper heat radiating plate
- 30:: copper circuit board
- 32:: one surface
- 34:: the other surface
- 50:: silver-plated layer
- 60:: recess
- 70:: resist
- 100:: ceramic circuit board
- 110:: heat sink
- 120:: electronic component
- 130:: solder layer
- 132:: solder layer
- 200:: electronic component module

## Claims

1. A ceramic circuit board (100) comprising:
a silicon nitride substrate (10);
a copper heat radiating plate (20) provided on one surface (12) of the silicon nitride substrate (10);
a copper circuit board (30)
provided on the other surface (14) of the silicon nitride substrate (10); and
a silver-plated layer (50) provided on at least a part of the other surface (34) of the copper circuit board (30), which is located on a side opposite to a main surface of the copper circuit board (30) facing the other surface (14) of the silicon nitride substrate (10),
**characterised in that**
the silver-plated layer (50) is formed in a recess (60) provided on the other surface (34) of the copper circuit board (30) , and a part of the lower surface of the silver-plated layer (50) is formed in a region outside the recess (60).

2. The ceramic circuit board (100) according to claim 1,
wherein, in one of cross-sectional views of the copper circuit board (30) when viewed in a thickness direction, the silver-plated layer (50) has a U shape that is open in a direction from the one surface (32) to the other surface (34) of the copper circuit board (30).

3. The ceramic circuit board (100) according to claim 1 or 2,
wherein, in one of cross-sectional views of the copper circuit board (30) when viewed in a thickness direction, the copper circuit board (30) does not include a side etching portion below a region where the silver-plated layer (50) is formed.

4. The ceramic circuit board (100) according to any one of claims 1 to 3,
wherein when the other surface (34) of the copper circuit board (30) is viewed in a perpendicular direction, a coating area of the silver-plated layer (50) with respect to an entire surface in the recess (60) is equal to or more than 80% and equal to or less than 100%.

5. The ceramic circuit board (100) according to any one of claims 1 to 4,
wherein a depth of the recess (60) measured by two-dimensional contour shape measurement is equal to or more than 1 um and equal to or less than 50 µm.

6. The ceramic circuit board (100) according to any one of claims 1 to 5,
wherein a thickness of the silver-plated layer (50) is equal to or more than 0.1 um and equal to or less than 3.0 um.

7. The ceramic circuit board (100) according to any one of claims 1 to 6,
wherein when the other surface (34) of the copper circuit board (30) is viewed in a perpendicular direction, a coating area of the silver-plated layer (50) with respect to an entire surface on the other surface (34) side of the copper circuit board (30) is equal to or more than 10% and equal to or less than 90%.

8. The ceramic circuit board (100) according to any one of claims 1 to 7,
wherein a surface roughness Ra of the silver-plated layer (50) measured in accordance with JIS B 0601-1994 is equal to or more than 0.01 um and equal to or less than 0.9 um.

9. The ceramic circuit board (100) according to any one of claims 1 to 8,
wherein a size of a copper particle of the copper circuit board (30) is equal to or more than 30 um and equal to or less than 600 µm.

10. The ceramic circuit board according to any one of claims 1 to 9,
wherein a silver-copper brazing material layer is provided in at least one of a space between the copper heat radiating plate (20) and the silicon nitride substrate (10) and a space between the copper circuit board (30) and the silicon nitride substrate (10), and
the silver-copper brazing material of the silver-copper brazing material layer is selected from an Ag-Cu-Ti brazing material, an Ag-Cu-In-Ti brazing material, and an Ag-Cu-Sn-Ti brazing material or a combination thereof, wherein the compounding ratio of Ag, Cu, and Sn or In is Ag: equal to or more than 85.0 parts by mass and equal to or less than 95.0 parts by mass, Cu: equal to or more than 5.0 parts by mass and equal to or less than 13.0 parts by mass, and Sn or In: equal to or more than 0.4 parts by mass and equal to or less than 3.5 parts by mass.

11. The ceramic circuit board (100) according to any one of claims 1 to 10,
wherein when a thickness of the silicon nitride substrate (10) is T1, a thickness of the copper heat radiating plate (20) is T2, and a thickness of the copper circuit board (30) is T3, T1, T2, T3 satisfy 1 ≤ (T2 + T3)/T1 ≤ 15.

12. The ceramic circuit board according to any one of claims 1 to 11,
wherein the silver-plated layer (50) is not formed on the side surface of the copper circuit board (30).

13. An electronic component module (200) comprising:
the ceramic circuit board (100) according to any one of claims 1 to 12;
an electronic component (120) provided on the copper circuit board (30) of the ceramic circuit board (100); and
a heat sink (110) provided on the copper heat radiating plate (20) of the ceramic circuit board (100).

## Patentansprüche

1. Keramikleiterplatte (100), die Folgendes umfasst:
ein Siliziumnitrid-Substrat (10);
eine Kupfer-Wärmestrahlungsplatte (20), die auf einer Oberfläche (12) des Siliziumnitrid-Substrats (10) vorgesehen ist;
eine Kupferleiterplatte (30), die auf der anderen Oberfläche (14) des Siliziumnitrid-Substrats (10) vorgesehen ist; und
eine Versilberungsschicht (50), die auf mindestens einem Teil der anderen Oberfläche (34) der Kupferleiterplatte (30) vorgesehen ist, die sich auf einer Seite befindet, die einer Hauptfläche der Kupferleiterplatte (30) gegenüberliegt, die der anderen Oberfläche (14) des Siliziumnitrid-Substrats (10) zugewandt ist,
**dadurch gekennzeichnet, dass** die Versilberungsschicht (50) in einer Ausnehmung (60) ausgebildet ist, die auf der anderen Oberfläche (34) der Kupferleiterplatte (30) vorgesehen ist, und ein Teil der Unterseite der Versilberungsschicht (50) in einem Bereich außerhalb der Ausnehmung (60) ausgebildet ist.

2. Keramikleiterplatte (100) nach Anspruch 1,
wobei in einer der Querschnittsansichten der Kupferleiterplatte (30), in einer Dickenrichtung betrachtet, die Versilberungsschicht (50) eine U-Form aufweist, die in einer Richtung von der einen Oberfläche (32) zu der anderen Oberfläche (34) der Kupferleiterplatte (30) offen ist.

3. Keramikleiterplatte (100) nach Anspruch 1 oder 2,
wobei in einer der Querschnittsansichten der Kupferleiterplatte (30, in einer Dickenrichtung betrachtet, die Kupferleiterplatte (30) keinen seitlichen Ätzabschnitt unterhalb eines Bereichs enthält, in dem die Versilberungsschicht (50) ausgebildet ist.

4. Keramikleiterplatte (100) nach einem der Ansprüche 1 bis 3,
wobei, wenn die andere Oberfläche (34) der Kupferleiterplatte (30) in einer senkrechten Richtung betrachtet wird, ein Beschichtungsbereich der Versilberungsschicht (50) in Bezug auf eine gesamte Oberfläche in der Ausnehmung (60) gleich oder mehr als 80 % und gleich oder weniger als 100 % ist.

5. Keramikleiterplatte (100) nach einem der Ansprüche 1 bis 4,
wobei eine durch zweidimensionale Konturformmessung gemessene Tiefe der Ausnehmung (60) gleich oder größer als 1 µm und gleich oder kleiner als 50 µm ist.

6. Keramikleiterplatte (100) nach einem der Ansprüche 1 bis 5,
wobei eine Dicke der Versilberungsschicht (50) gleich oder mehr als 0,1 µm und gleich oder weniger als 3,0 µm beträgt.

7. Keramikleiterplatte (100) nach einem der Ansprüche 1 bis 6,
wobei, wenn die andere Oberfläche (34) der Kupferleiterplatte (30) in einer senkrechten Richtung betrachtet wird, ein Beschichtungsbereich der Versilberungsschicht (50) in Bezug auf eine gesamte Oberfläche auf der Seite der anderen Oberfläche (34) der Kupferleiterplatte (30) gleich oder mehr als 10 % und gleich oder weniger als 90 % ist.

8. Keramikleiterplatte (100) nach einem der Ansprüche 1 bis 7,
wobei eine gemäß JIS B 0601-1994 gemessene Oberflächenrauigkeit Ra der Versilberungsschicht (50) gleich oder mehr als 0,01 µm und gleich oder weniger als 0,9 µm beträgt.

9. Keramikleiterplatte (100) nach einem der Ansprüche 1 bis 8,
wobei eine Größe eines Kupferpartikels der Kupferleiterplatte (30) gleich oder größer als 30 µm und gleich oder kleiner als 600 µm ist.

10. Keramikleiterplatte nach einem der Ansprüche 1 bis 9,
wobei eine Silber-Kupfer-Lötmaterialschicht in mindestens einem von einem Raum zwischen der Kupfer-Wärmestrahlungsplatte (20) und dem Siliziumnitrid-Substrat (10) und einem Raum zwischen der Kupferleiterplatte (30) und dem Siliziumnitrid-Substrat (10) vorgesehen ist, und
das Silber-Kupfer-Lötmaterial der Silber-Kupfer-Lötmaterialschicht ausgewählt ist aus einem Ag-Cu-Ti-Lötmaterial, einem Ag-Cu-In-Ti-Lötmaterial und einem Ag-Cu-Sn-Ti-Lötmaterial oder einer Kombination davon, wobei das Mischungsverhältnis von Ag, Cu und Sn oder In Folgendes ist: Ag: gleich oder mehr als 85,0 Massenteile und gleich oder weniger als 95,0 Massenteile, Cu: gleich oder mehr als 5,0 Massenteile und gleich oder weniger als 13,0 Massenteile, und Sn oder In: gleich oder mehr als 0,4 Massenteile und gleich oder weniger als 3,5 Massenteile.

11. Keramikleiterplatte (100) nach einem der Ansprüche 1 bis 10,
wobei, wenn eine Dicke des Siliziumnitrid-Substrats (10) T1 ist, eine Dicke der Kupfer-Wärmestrahlungsplatte (20) T2 ist und eine Dicke der Kupferleiterplatte (30) T3 ist, T1, T2, T3 1 ≤ (T2 + T3)/T1 ≤ 15 genügt.

12. Keramikleiterplatte nach einem der Ansprüche 1 bis 11,
wobei die Versilberungsschicht (50) nicht auf der Seitenfläche der Kupferleiterplatte (30) ausgebildet ist.

13. Elektronisches Komponentenmodul (200), das Folgendes umfasst:
die Keramikleiterplatte (100) nach einem der Ansprüche 1 bis 12;
eine elektronische Komponente (120), die auf der Kupferleiterplatte (30) der Keramikleiterplatte (100) vorgesehen ist; und
eine Wärmesenke (110), die auf der Kupfer-Wärmestrahlungsplatte (20) der Keramikleiterplatte (100) vorgesehen ist.

## Revendications

1. Carte de circuit imprimé en céramique (100) comprenant :
un substrat en nitrure de silicium (10) ;
une plaque de rayonnement thermique en cuivre (20) placée sur une surface (12) du substrat en nitrure de silicium (10) ;
une carte de circuit imprimé en cuivre (30) prévue sur l'autre surface (14) du substrat de nitrure de silicium (10) ; et
une couche d'argentée (50) prévue sur au moins une partie de l'autre surface (34) de la carte de circuit imprimé en cuivre (30), qui est située sur un côté opposé à une surface principale de la carte de circuit imprimé en cuivre (30) faisant face à l'autre surface (14) du substrat en nitrure de silicium (10),
**caractérisée en ce que** la couche argentée (50) est formée dans un évidement (60) prévu sur l'autre surface (34) de la carte de circuit imprimé en cuivre (30), et une partie de la surface inférieure de la couche argentée (50) est formée dans une région située à l'extérieur de l'évidement (60).

2. Carte de circuit imprimé en céramique (100) selon la revendication 1,
dans laquelle, dans l'une de vues en coupe transversale de la carte de circuit imprimé en cuivre (30), vue dans une direction d'épaisseur, la couche argentée (50) a une forme U qui est ouverte dans une direction allant d'une surface (32) à l'autre surface (34) de la carte de circuit imprimé en cuivre (30) .

3. Carte de circuit imprimé en céramique (100) selon la revendication 1 ou 2,
dans laquelle, dans l'une des vues en coupe transversale de la carte de circuit imprimé en cuivre (30), vue dans la direction d'épaisseur, la carte de circuit imprimé en cuivre (30) ne comprend pas de partie de gravure latérale en dessous d'une région où la couche argentée (50) est formée.

4. Carte de circuit imprimé en céramique (100) selon l'une quelconque des revendications 1 à 3,
dans laquelle, lorsque l'autre surface (34) de la carte de circuit imprimé en cuivre (30) est vue dans une direction perpendiculaire, une zone de revêtement de la couche argentée (50) par rapport à une surface entière dans l'évidement (60) est égale ou supérieure à 80 % et égale ou inférieure à 100 %.

5. Carte de circuit imprimé en céramique (100) selon l'une quelconque des revendications 1 à 4,
dans laquelle une profondeur de l'évidement (60) mesurée par une mesure bidimensionnelle de la forme du contour est égale ou supérieure à 1 um et égale ou inférieure à 50 um.

6. Carte de circuit imprimé en céramique (100) selon l'une quelconque des revendications 1 à 5,
dans laquelle une épaisseur de la couche argentée (50) est égale ou supérieure à 0,1 um et égale ou inférieure à 3,0 µm.

7. Carte de circuit imprimé en céramique (100) selon l'une quelconque des revendications 1 à 6,
dans laquelle, lorsque l'autre surface (34) de la carte de circuit imprimé en cuivre (30) est vue dans une direction perpendiculaire, une zone de revêtement de la couche argentée (50) par rapport à une surface entière sur le côté de l'autre surface (34) de la carte de circuit imprimé en cuivre (30) est égale ou supérieure à 10 % et égale ou inférieure à 90 %.

8. Carte de circuit imprimé en céramique (100) selon l'une quelconque des revendications 1 à 7,
dans laquelle une rugosité de surface Ra de la couche argentée (50) mesurée conformément à la norme JIS B 0601-1994 est égale ou supérieure à 0,01 um et égale ou inférieure à 0,9 µm.

9. Carte de circuit imprimé en céramique (100) selon l'une quelconque des revendications 1 à 8,
dans laquelle la taille d'une particule de cuivre de la carte de circuit imprimé en cuivre (30) est égale ou supérieure à 30 um et égale ou inférieure à 600 µm.

10. Carte de circuit imprimé en céramique selon l'une des revendications 1 à 9,
dans laquelle une couche de matériau de brasage argent-cuivre est prévue dans au moins l'un d'un espace entre la plaque de rayonnement thermique en cuivre (20) et le substrat en nitrure de silicium (10) et d'un espace entre la carte de circuit imprimé en cuivre (30) et le substrat en nitrure de silicium (10), et
le matériau de brasage argent-cuivre de la couche de matériau de brasage argent-cuivre est choisi parmi un matériau de brasage Ag-Cu-Ti, un matériau de brasage Ag-Cu-In-Ti et un matériau de brasage Ag-Cu-Sn-Ti ou une combinaison de ceux-ci, le rapport de composition de Ag, Cu et Sn ou In étant comme suit : Ag : égal ou supérieur à 85,0 en masse et inférieur ou égal à 95,0 en masse, Cu : supérieur ou égal à 5,0 en masse et inférieur ou égal à 13,0 en masse, et Sn ou In : supérieur ou égal à 0,4 en masse et inférieur ou égal à 3,5 en masse.

11. Carte de circuit imprimé en céramique (100) selon l'une quelconque des revendications 1 à 10,
dans laquelle, lorsqu'une épaisseur du substrat de nitrure de silicium (10) est T1, une épaisseur de la plaque de rayonnement thermique en cuivre (20) est T2, et une épaisseur de la carte de circuit imprimé en cuivre (30) est T3, T1, T2, T3 satisfont 1 ≤ (T2 + T3)/T1 ^{<}₋ 15.

12. Circuit imprimé en céramique selon l'une des revendications 1 à 11,
dans laquelle la couche argentée (50) n'est pas formée sur la surface latérale de la carte de circuit imprimé en cuivre (30) .

13. Module de composants électroniques (200), comprenant :
la carte de circuit imprimé en céramique (100) selon l'une quelconque des revendications 1 à 12 ;
un composant électronique (120) prévu sur la carte de circuit imprimé en cuivre (30) de la carte de circuit imprimé en céramique (100) ; et
un dissipateur thermique (110) placé sur la plaque de rayonnement thermique en cuivre (20) de la carte de circuit imprimé en céramique (100).
